# EUROPÄISCHE PATENTSCHRIFT

(11) **EP 2 842 080 B1**
(45) Veröffentlichungstag und Bekanntmachung des Hinweises auf die Patenterteilung: **10.10.2018**
(21) Anmeldenummer: 13716959.5
(22) Anmeldetag: 08.04.2013
(51) Int. Cl.: G06K 19/077, H01L 23/00

(54) **HERSTELLUNG EINES PORTABLEN DATENTRÄGERS**
PRODUCTION OF A PORTABLE DATA STORAGE MEDIUM
FABRICATION D'UN SUPPORT DE DONNÉES PORTABLE

(30) Priorität: 26.04.2012 DE 102012008500
(43) Veröffentlichungstag der Anmeldung: 04.03.2015
(73) Patentinhaber: Giesecke+Devrient Mobile Security GmbH, 81677 München (DE)
(72) Erfinder: BRAUN, Andreas, 80798 München (DE)
(86) Internationale Anmeldenummer: PCT/EP2013/001033
(87) Internationale Veröffentlichungsnummer: WO 2013/159867

(56) Entgegenhaltungen:
- EP-A1- 0 517 071
- EP-A1- 2 058 753
- DE-C1- 10 124 770

## Beschreibung

Die Erfindung betrifft eine Substratanordnung zur Herstellung eines kartenförmigen Datenträgers, einen solchen kartenförmigen Datenträger in Form eines laminierten Schichtverbunds sowie Herstellungsverfahren für eine derartige Substratanordnung und einen derartigen Datenträger.

Es ist bekannt, bei der Herstellung kartenförmiger Datenträger mehrere Schichten aufeinander zu laminieren. Insbesondere ist es bekannt, auf ein Substrat eine Antenne in Form einer elektrischen Leiterbahn aufzubringen, diese mit einem Mikrochip elektrisch leitend zu verbinden und diese Anordnung beim Laminieren mit einer Deckschicht zu versehen.

Bei einem solchen Laminierprozess kann der Chip in das Substrat hineingedrückt werden und die elektrische Leiterbahn Scherkräften unterwerfen, die die Leiterbahn beschädigen oder gänzlich abreißen lassen. Ein derart hergestellter Datenträger funktioniert lediglich unzuverlässig oder gar nicht.

EP 2 058 753 A1 beschreibt eine Substratanordnung zur Herstellung eines kartenförmigen Datenträgers, z.B. eines RFID-Tags, umfassend ein Substrat sowie zumindest eine auf dem Substrat angeordnete elektrische Leiterbahn.

DE 10124 770 Cl beschreibt das Problem, dass Teile einer Leiterstruktur unter einem zu kontaktierenden Bauelement beim Kontaktieren in das Substrat gedrückt werden, wobei die Gefahr des Brechens der Leiterstruktur besteht. Zur Lösung des Problems wird offenbart, dass geeignete Materialien wie Kupfer oder Nickel ausgewählt werden, welche eine ausreichende Elastizität zumindest bei kleinen Unebenheiten besitzen.

Es ist daher die Aufgabe der vorliegenden Erfindung, bei einem derartigen Herstellungsprozess eine höhere Ausbeute an einwandfrei funktionierenden kartenförmigen Datenträgern sicherzustellen.

Diese Aufgabe wird durch eine Substratanordnung, einen kartenförmigen Datenträger sowie entsprechende Herstellungsverfahren gemäß den unabhängigen Ansprüchen gelöst. In davon abhängigen Ansprüchen sind vorteilhafte Ausgestaltungen und Weiterbildungen der Erfindung angegeben.

Die erfindungsgemäße Substratanordnung umfasst eine Stabilisierungsschicht, die einen Bereich des Substrats des zukünftigen Datenträgers bedeckt. Die Leiterbahn erstreckt sich dann von einer vom dem Substrat abgewandten Seite der Stabilisierungsschicht zu einem nicht von der Stabilisierungsschicht bedeckten Bereich des Substrats. Bei einer Herstellung des Datenträgers basierend auf dieser Substratanordnung wird eine elektrische Komponente auf der Stabilisierungsschicht angeordnet, mit der Leiterbahn elektrisch leitend verbunden und schließlich wird eine sich über die elektrische Komponente erstreckende Deckschicht auflaminiert. Die Stabilisierungsschicht ist hierbei derart ausgestaltet und die Leiterbahn erstreckt sich derart von der Stabilisierungsschicht zu dem Substrat, dass die elektrische Komponente beim Auflaminieren der Deckschicht in elektrisch leitender Verbindung mit der Leiterbahn verbleibt.

Bei der Herstellung der Substratanordnung wird die Stabilisierungsschicht auf einen Bereich des Substrats aufgebracht und die Leiterbahn derart angeordnet, dass sie von einer vom Substrat abgewandten Seite der Stabilisierungsschicht zu einem nicht von der Stabilisierungsschicht bedeckten Bereich des Substrats verläuft. Hierbei wird die Stabilisierungsschicht und die Leiterbahn derart auf dem Substrat angeordnet, dass die elektrisch leitende Verbindung zwischen der Leiterbahn und der bei der anschließenden Herstellung des Datenträgers auf der Stabilisierungsschicht angeordnete elektrischen Komponente infolge des bei dem Auflaminieren der Deckschicht entstehende Drucks nicht beeinträchtigt wird oder gar reißt.

Bei der vorliegenden Erfindung verhindert die Stabilisierungsschicht und die über die Stabilisierungsschicht verlaufende Leiterbahn eine Unterbrechung der elektrisch leitenden Verbindung bei der Herstellung des Datenträgers durch den laminierungsbedingten Druck der elektrischen Komponente auf das Substrat, indem sie verhindert, dass die Leiterbahn durch diesen Druck derart deformiert wird, dass sie zerstört wird.

Vorzugsweise ist die Stabilisierungsschicht gegenüber dem Substrat leicht erhaben ausgebildet, so dass bei der Führung der Leiterbahn von der Stabilisierungsschicht in einen nicht von der Stabilisierungsschicht bedeckten Bereich des Substrats am Übergang zwischen Stabilisierungsschicht und Substrat mehr Leiterbahnmaterial benötigt wird, als ohne die Stabilisierungsschicht. Dieser "Überschuss" an Leiterbahnmaterial bewirkt oder ergänzt den zuvor erläuterten erfindungsgemäßen Effekt, denn anstatt zu reißen deformiert sich die Leiterbahn bei einwirkenden Scheerkräften nur im Bereich des Übergangs zwischen Stabilisierungsschicht und Substrat.

Bei dieser bevorzugten Ausführungsform ist die Stabilisierungsschicht dementsprechend derart ausgestaltet und die Leiterbahn erstreckt sich derart von der Stabilisierungsschicht zu dem Substrat, dass die Leiterbahn bei einem durch das Auflaminieren der Deckschicht bei der Herstellung des Datenträgers bewirkten Druck der Stabilisierungsschicht auf das Substrat im Wesentlichen nur gestaucht und/oder gebogen wird. Dies kann zum Beispiel dadurch erreicht werden, dass zumindest ein Randbereich der Stabilisierungsschicht, über den die Leiterbahn von der Stabilisierungsschicht zu dem Substrat verläuft, entsprechend geformt ist.

Besonders bevorzugt ist die Stabilisierungsschicht derart ausgestaltet und geformt, dass die Leiterbahn beim Laminieren lediglich gebogen wird und dadurch nur geringen mechanischen Belastungen ausgesetzt ist. Dies kann z.B. dadurch erreicht werden, dass der oder die Randbereiche von der Stabilisierungsschicht zu dem Substrat hin auslaufen, d.h. sich in Richtung des Substrats keilförmig verjüngen bzw. kontinuierlich dünner werden.

Alternativ oder zusätzlich kann die Stabilisierungsschicht derart ausgestaltet und auf dem Substrat angeordnet sein, dass sie bei der Herstellung des Datenträgers einen durch das Auflaminieren der Deckschicht bewirkten Druck der elektrischen Komponente auf das Substrat flächig verteilt und dadurch reduziert. Dies führt dazu, dass im Vergleich zu einer direkt auf dem Substrat angeordneten elektrischen Komponente die Stabilisierungsschicht bei dem Laminieren weniger weit in das Substrat hineingedrückt wird und dadurch die auf die Leiterbahn wirkenden Kräfte reduziert werden. Um die oben beschriebene Druckreduzierung durch flächiges Verteilen des Drucks leicht zu erzielen, ist besonders bevorzugt eine dem Substrat zugewandte Fläche der Stabilisierungsschicht größer als eine dem Substrat zugewandte Fläche der auf der Stabilisierungsschicht anordenbaren und mit der Leiterbahn verbindbaren elektrischen Komponente.

Vorzugsweise ist außerdem das Material der Stabilisierungsschicht härter als das Material des Substrats. Dies führt dazu, dass die elektrische Komponente bei dem Laminiervorgang weniger weit in die Stabilisierungsschicht hineingedrückt wird, als bei direktem Anordnen der elektrischen Komponente auf dem Substrat.

Das Material der Stabilisierungsschicht besitzt vorzugsweise einen Schmelzpunkt, der größer ist, als eine zum Auflaminieren der Deckschicht auf die Substratanordnung erforderliche Temperatur, damit die Stabilisierungsschicht bei dem Laminiervorgang nicht erweicht.

Ein erfindungsgemäße kartenförmiger Datenträger umfasst die zuvor beschriebene Substratanordnung und eine darauf auflaminierte Deckschicht sowie eine auf der Stabilisierungsschicht angeordnete und mit der Leiterbahn elektrische leitend verbundene elektrische Komponente, über die sich die Deckschicht hinweg erstreckt.

Bei der Herstellung eines erfindungsgemäßen Datenträgers ausgehend von einer erfindungsgemäßen Substratanordnung wird eine elektrische Komponente auf der Stabilisierungsschicht angeordnet und mit der Leiterbahn elektrisch leitend verbunden. Im Rahmen eines Laminiervorgangs wird dann die Deckschicht entsprechend auf die Substratanordnung auflaminiert.

Bei einem erfindungsgemäßen Datenträger ist eine dem Substrat zugewandte Fläche der Stabilisierungsschicht vorzugsweise größer als eine dem Substrat zugewandte Fläche der elektrischen Komponente, um die oben beschriebene Druckreduktion auf das Substrat durch flächiges Verteilen des Drucks zu erzielen.

Die Deckschicht kann direkt auf das Substrat auflaminiert sein. Alternativ dazu kann der Datenträger insbesondere auch eine zwischen dem Substrat und der Deckschicht liegende Zwischenschicht umfassen, die zumindest die elektrische Komponente ausspart.

Bei der elektrischen Komponente kann es sich um einen Mikrochip handeln. Die Leiterbahn bildet gemäß einer bevorzugten Ausführungsform eine mit einem solchen Mikrochip verbundene Antenne. Die elektrische Komponente und die damit verbundene Leiterbahn, z.B. in Form einer Antenne, können sich in einer bevorzugten Ausführungsform gemeinsam auf der Stabilisierungsschicht befinden. Dies könnte dann vorteilhafterweise sowohl zur Stabilisierung der elektrischen Komponente und der Antenne als auch als Isolator in einem Brückenbereich der Leiterbahn, z.B. der Antenne, dienen. Besonders bevorzugt ist der erfindungsgemäße kartenförmige Datenträger eine Chipkarte, Smart-Card, SIM-Mobilfunkkarte, sichere Multimediakarte oder dergleichen.

Weitere Merkmale und Vorteile der Erfindung ergeben sich aus der nachfolgenden Beschreibung von erfindungsgemäßen Ausführungsbeispielen sowie weiteren Ausführungsalternativen im Zusammenhang mit den Zeichnungen, die schematisch zeigen:
- Figur 1: ein erfindungsgemäßer kartenförmiger Datenträger in Draufsicht,
- Figur 2a: eine Schnittdarstellung einer erfindungsgemäßen Substratanordnung und weiterer Bauteile zum Erzeugen des kartenförmigen Datenträgers von Figur 1,
- Figur 2b: eine Schnittdarstellung des aus den Bauteilen von Figur 2a erzeugten kartenförmigen Datenträgers von Figur 1,
- Figur 3: die Schritte eines entsprechenden Verfahrens zum Erzeugen des kartenförmigen Datenträgers der Figuren 1 und 2b,
- Figur 4a: eine Schnittdarstellung einer Substratanordnung und weiterer Bauteile zum Erzeugen eines kartenförmigen Datenträgers gemäß dem Stand der Technik,
- Figur 4b: eine Schnittdarstellung eines aus den Bauteilen von Figur 4a erzeugten defekten kartenförmigen Datenträgers gemäß dem Stand der Technik.

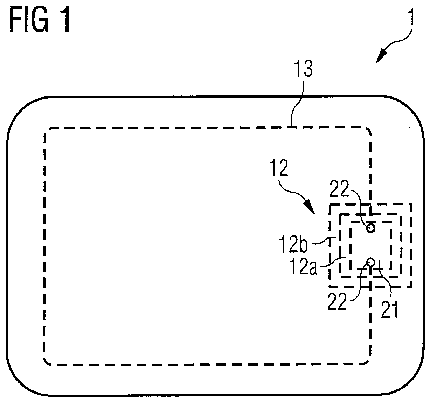

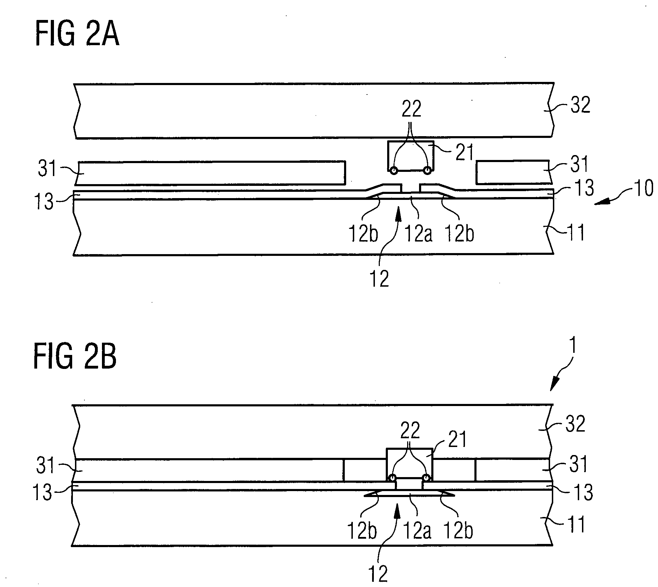

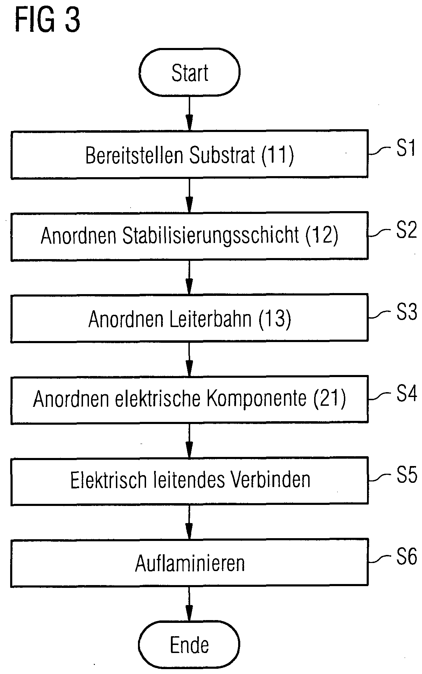

In Figur 1 ist ein erfindungsgemäßer kartenförmiger Datenträger 1 in Draufsicht dargestellt und in Figur 2b als Schnittdarstellung. Figur 2a zeigt eine Schnittdarstellung einer Substratanordnung 10 und weiterer Teile 21, 31, 32 zum Erzeugen des kartenförmigen Datenträgers 1 der Figuren 1 und 2b. Die Substratanordnung 10 umfasst erfindungsgemäß eine Stabilisierungsschicht 12. In Figur 3 sind die Schritte eines Verfahrens zum Herstellen der Substratanordnung 10 als Halbzeug und zum nachfolgenden Erzeugen des Datenträgers 1 unter Verwendung der Substratanordnung 10 dargestellt.

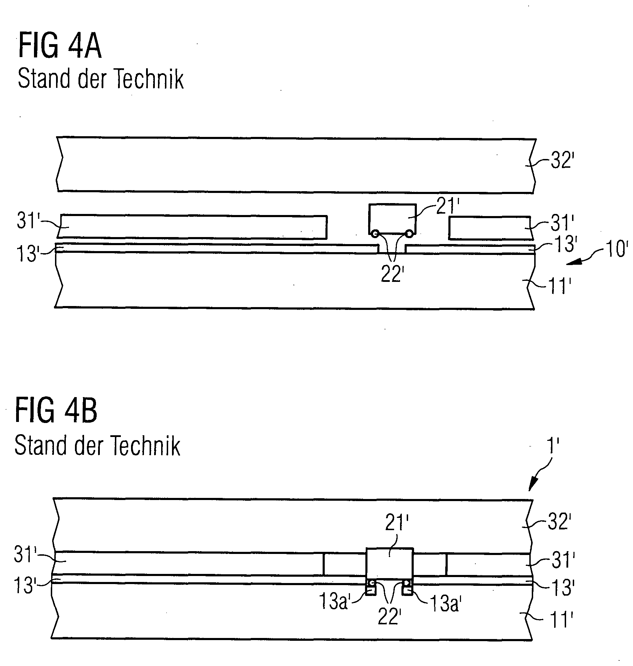

Figur 4a zeigt zum Vergleich in Analogie zu Figur 2a eine Schnittdarstellung einer Substratanordnung 10' nach dem Stand der Technik und weiterer Teile 21', 31', 32' zum Erzeugen des in Figur 4b als Schnittdarstellung dargestellten kartenförmigen Datenträgers 1' nach dem Stand der Technik. Die Substratanordnung 10' nach dem Stand der Technik und der daraus erzeugte Datenträger 1' umfassen nicht die Stabilisierungsschicht der Figuren 1, 2a und 2b.

Bei dem erfindungsgemäßen Verfahren wird, wie in Figur 3 dargestellt, zunächst im Schritt S1 ein Substrat 11 bereitgestellt. Aus diesem Substrat 11 wird dann eine Substratanordnung 10 als Halbzeug für den kartenförmigen Datenträger 1 erzeugt, indem in dem Schritt S2 eine Stabilisierungsschicht 12 und anschließend in dem Schritt S3 eine Leiterbahn 13 auf das Substrat 11 aufgebracht wird.

Die Leiterbahn 13 erstreckt sich von der Substratoberfläche über Randbereiche 12b der Stabilisierungsschicht 12 hinweg bis in einen Zentralbereich 12a der Stabilisierungssicht 12. Die Leiterbahn 13 ist vorliegend auf das Substrat aufgedruckt und bildet eine Antennenspule, die in Figur 1 schematisch als einzelne Antennenwindung dargestellt ist, jedoch in der Praxis auch mehrere Windungen aufweisen kann.

In dem Verfahrensschritt S4 wird dann ein Mikrochip 21 auf der Stabilisierungsschicht 12 angeordnet und im Schritt S5 gemäß der Flip-Chip Technologie mittels den Kontaktierungselementen 22 mit der Leiterbahn 13 elektrisch leitend verbunden. Dementsprechend handelt es sich vorliegend bei dem Datenträger 1 um eine Chipkarte mit Kontaktlosfunktion. Anstatt des Mikrochips 21 kann natürlich grundsätzlich auch eine beliebige elektrische Komponente aufgebracht und mit der Leiterbahn 13 elektrisch leitend verbunden werden. Danach wird in dem Verfahrensschritt S6 zum Fertigstellen des kartenförmigen Datenträgers 1 eine Zwischenschicht 31 und eine Deckschicht 32, die sich über den Mikrochip 21 hinweg erstreckt, auf das Substrat 11 auflaminiert. Die Leiterbahn 13 befindet dann dementsprechend zwischen dem Substrat 11 und der Zwischenschicht 31.

Bei dem Laminieren gemäß Verfahrensschritt S6 wird der Mikrochip 21 von der Deckschicht 32 in Richtung des Substrats 11 gedrückt. Dadurch wird, wie in Figur 2b ersichtlich, die Stabilisierungsschicht 12 mitsamt dem darauf angeordneten Mikrochip 21 in das Substrat 11 hineingedrückt, wobei jedoch die Leiterbahn 13 auf Grund der geeignet ausgestalteten Stabilisierungsschicht 12 nicht unterbrochen wird.

Im Gegensatz dazu ist bei der in Figur 4a dargestellten Substratanordnung 10' gemäß dem Stand der Technik keine Stabilisierungsschicht auf dem Substrat 10' angeordnet, sondern nur eine Leiterbahn 13'. Dementsprechend wird bei dieser Substratanordnung 10' ein Mikrochip 21' direkt auf dem Substrat 11' angeordnet und mittels Kontaktierungselementen 22' mit der Leiterbahn 13' elektrisch leitend verbunden. Anschließend wird eine Zwischenschicht 31' und eine sich über den Chip 21' hinweg erstreckende Deckschicht 32' auf das Substrat 11' auflaminiert. Bei diesem Auflaminieren wird der Chip 21' in das Substrat 11' hineingedrückt, welches bei der beim Laminieren angewendeten erhöhten Temperatur weich ist und sich somit bei dem Laminieren deformiert, d.h. z.B. gedehnt wird bzw. fließt. Wie in Figur 4b ersichtlich ist, reißen dadurch die beiden Endstücke 13a' von der Leiterbahn 13' ab und der Kontakt zwischen Chip 21' und Leiterbahn 13' wird unterbrochen, weshalb der fertige Datenträger 1' nicht funktioniert. Ebenso kann es dazu kommen, dass die Leiterbahn 13' Risse bekommt und dadurch der Datenträger 1' nicht zuverlässig funktioniert.

Bei der vorliegenden Erfindung hingegen schützt, wie erwähnt, die Stabilisierungsschicht 12 die Leiterbahn 13 vor einer solchen Unterbrechung und/oder derartigen Rissen auf die im Folgenden erläuterte Art- und Weise:

Die Stabilisierungsschicht 12 ist härter als das Substrat 11, bevorzugt weist sie eine größere Shore A und/oder Shore D Härte auf als das Substrat 11. Folglich wird der auf der Stabilisierungsschicht 12 angeordnete Chip 21 nicht oder nicht so weit in die Stabilisierungsschicht 12 hineingedrückt wie bei dem Stand der Technik der Figuren 4a und 4b der Chip 21' in das Substrat 11' hineingedrückt wird. Vielmehr wird der Chip 21 mitsamt der gesamten Stabilisierungsschicht 12 in das Substrat 11 hineingedrückt. Die zu dem Substrat 11 weisende Seite der Stabilisierungsschicht 12 ist jedoch deutlich größer, als die zum Substrat 11 weisende Seite des Chips 21. Folglich wird auch der Chip 21 mitsamt der Stabilisierungsschicht 12 weniger weit in das Substrat 11 hineingedrückt, als ohne die Stabilisierungsschicht 12 bei dem Stand der Technik gemäß Figur 4b. Insgesamt wird daher die Leiterbahn 13 bei der Anordnung gemäß Figuren 1, 2a und 2b weniger stark deformiert als bei dem Stand der Technik gemäß Figur 4b. Bereits durch diesen Effekt kann die Leiterbahn 13 - bei geeigneter Ausgestaltung der Stabilisierungsschicht 12, d.h. insbesondere, wenn diese hinreichend groß ist - sicher vor den oben beschriebenen Beschädigungen durch den Laminiervorgang geschützt werden.

Die Leiterbahn 13 wird vorliegend aber auch zusätzlich dadurch geschützt, dass sie bei dem Hineindrücken des Chips 21 mitsamt der Stabilisierungsschicht 12 in das Substrat 11 anders deformiert wird, als bei dem Hineindrücken des Chips 21' in das Substrat 11' gemäß dem Stand der Technik von Figuren 4a und 4b. Bei dem Stand der Technik wirken bei dem Laminiervorgang Kräfte, insbesondere Scherkräfte, auf die Leiterbahn 13', die zu einer Dehnung des Leiterbahnmaterials führen. Daher reißt diese bei dem Laminieren leicht ab oder bekommt Risse. Die Stabilisierungsschicht 12 von Figur 2a hingegen ist jedoch gegenüber dem Substrat 11 erhaben. Durch die Führung der Leiterbahn 13 von der gegenüber dem Substrat 11 leicht erhabenen Stabilisierungsschicht 12 in einen nicht von der Stabilisierungsschicht 12 bedeckten Bereich des Substrats 11 wird beim Übergang von der Stabilisierungsschicht 12 zu dem Substrat 11 mehr Leiterbahnmaterial benötigt, als ohne die Stabilisierungsschicht 12. Unter anderen dieser "Überschuss" ist dafür verantwortlich, dass die Leiterbahn 13 nicht abgeschert oder in sonstiger Weise auseinandergerissen wird. Zudem besitzt die Stabilisierungsschicht 12 einen Randbereich 12b, der zum Rand hin auf der vom Substrat wegweisenden Seite abgeschrägt ist. Insgesamt wird daher die Leiterbahn 13 bei dem Laminiervorgang in der in den Figuren 2a und 2b ersichtlichen Art- und Weise gebogen und dabei geringfügig gestaucht. Durch das Vermeiden eines Dehnens der Leiterbahn 13 wird diese also zusätzlich geschont.

Bei dem dargestellten Ausführungsbeispiel gemäß Figuren 1, 2a und 2b wird die Leiterbahn 13 also sowohl dadurch geschützt, dass der Chip 21 mitsamt der Stabilisierungsschicht 12 weniger weit in das Substrat 11 hineingedrückt wird, als dies ohne die Stabilisierungsschicht 12 der Fall wäre, als auch dadurch, dass die Leiterbahn 13 bei diesem Hineindrücken in schonender Weise deformiert wird. In der Folge reißt die Leiterbahn 13 bei dem Laminiervorgang nicht bzw. bekommt weniger oder gar keine Risse, sogar wenn größere Prozessfenster, d.h. Toleranzen der Prozessparameter wie Abmessungen der Komponenten des Datenträgers 1, der Laminiertemperatur, des Laminierdrucks etc., vorgegeben werden. Grundsätzlich kann die Leiterbahn 13 aber auch bereits durch einen dieser beiden zuvor genannten Effekte hinreichend vor Beschädigung bei dem Laminieren geschützt werden.

Anstatt des in Figur 2a dargestellten abgeschrägten Randbereichs 12b, könnte der Randbereich 12b auch nicht zum Rand hin abgeschrägt sein, d.h. an dem Rand eine Stufe bilden. Dann würde die Leiterbahn 13 bei dem Eindrücken der Stabilisierungsschicht 12 in das Substrat 11 im Wesentlichen nur gestaucht werden. Dies würde die Leiterbahn 13 normalerweise immer noch weniger leicht schädigen als das Dehnen der Leiterbahn 13 gemäß dem Stand der Technik der Figuren 4a und 4b, jedoch würde es die Leiterbahn 13 eher schädigen, als der zu bevorzugende zuvor beschriebene überwiegende Biegevorgang.

Bei dem Ausführungsbeispiel gemäß Figur 2b wird die Stabilisierungsschicht 12 nahezu undeformiert in das Substrat 11 hineingedrückt. Alternativ dazu kann die Stabilisierungsschicht 12 auch derart ausgestaltet sein, dass sie sich in den Randbereichen 12b bei dem Eindrücken der Stabilisierungsschicht 12 in das Substrat 11 von dem Substrat 11 weg biegt.

Die Stabilisierungsschicht 12 kann einen gedruckten Lack, insbesondere einen in Siebdruckverfahren aufgebrachten Lack umfassen. Beispielsweise kann der Lack lösungsmittelhaltig, wasserbasiert, durch Ultraviolettstrahlung härtend, elektronenstrahlhärtend und/oder ein konventioneller Lack sein. Ebenso kann die Stabilisierungsschicht 12 zwei Materialkomponenten umfassen, die in Kontakt zueinander oder bei Vermischen aushärten. Außerdem kann die Stabilisierungsschicht 12 eine auf das Substrat 11 aufgeklebte stabilisierende Schicht ("Patch") umfassen, z.B. eine biaxial orientierte PET Folie. Die Stabilisierungsschicht 12 ist vorzugsweise nicht elektrisch leitend und ihre Materialstärke ist vorzugsweise derart abgestimmt, dass bei dem Laminiervorgang die Leiterbahn 13 im Wesentlichen nur gestaucht und/oder gebogen wird.

Bei dem kartenförmigen Datenträger 1 kann es nicht nur wie vorliegend um eine beliebige Chipkarte (z.B. Smart Card, SIM-Mobilfunkkarte, Identitätskarte, Ausweis, etc.) handeln, sondern grundsätzlich auch um einen beliebigen kartenförmigen Datenträger mit oder auch ohne Kontaktlosfunktion. Ebenfalls kann es sich bei dem kartenförmigen Datenträger auch um ein entsprechendes Inlay zum Einbringen in einen der zuvor genannten Datenträger oder in einen beliebigen sonstigen kartenförmigen oder nicht kartenförmigen Datenträger handeln.

## Patentansprüche

1. Substratanordnung (10) zur Herstellung eines kartenförmigen Datenträgers (1), umfassend ein Substrat (11) sowie zumindest eine auf dem Substrat (11) angeordnete elektrische Leiterbahn (13), **dadurch gekennzeichnet, dass**
die Substratanordnung (10) eine einen Bereich des Substrats (11) bedeckende Stabilisierungsschicht (12) umfasst, und
die Leiterbahn (13) sich von einer vom dem Substrat (11) abgewandten Seite der Stabilisierungsschicht (12) zu einem nicht von der Stabilisierungsschicht (12) bedeckten Bereich des Substrats (11) erstreckt, wobei
die Stabilisierungsschicht (12) derart ausgestaltet ist, dass beim Auflaminieren die Stabilisierungsschicht (12) in das Substrat (11) eingedrückt wird, und die Leiterbahn (13) sich derart von der Stabilisierungsschicht (12) zu dem Substrat (11) erstreckt, dass eine bei der Herstellung des Datenträgers (1) auf der Stabilisierungsschicht (12) angeordnete und mit der Leiterbahn (13) elektrisch leitend verbundene elektrische Komponente (21) bei einem Auflaminieren einer sich über die elektrische Komponente (21) erstreckenden Deckschicht (32) in elektrisch leitender Verbindung mit der Leiterbahn (13) verbleibt.

2. Substratanordnung (10) nach Anspruch 1, **dadurch gekennzeichnet, dass** die Stabilisierungsschicht (12) derart ausgestaltet ist und die Leiterbahn (13) sich derart von der Stabilisierungsschicht (12) zu dem Substrat (11) erstreckt, dass die Leiterbahn (13) bei einem durch das Auflaminieren der Deckschicht (32) bei der Herstellung des Datenträgers (1) bewirkten Druck der Stabilisierungsschicht (12) auf das Substrat (11) im Wesentlichen nur gestaucht und/oder gebogen wird.

3. Substratanordnung (10) nach Anspruch 1 oder 2, **dadurch gekennzeichnet, dass** zumindest ein Randbereich der Stabilisierungsschicht (12), über den die Leiterbahn (13) von der Stabilisierungsschicht (12) zu dem Substrat (11) verläuft, derart ausgestaltet ist, dass die Leiterbahn (13) bei einem durch das Auflaminieren der Deckschicht (32) bei der Herstellung des Datenträgers (1) bewirkten Druck der Stabilisierungsschicht (12) auf das Substrat (11) im Wesentlichen nur gestaucht und/oder gebogen wird.

4. Substratanordnung (10) nach Anspruch 3, **dadurch gekennzeichnet, dass** der zumindest eine Randbereich (12b) der Stabilisierungsschicht (12) von der Stabilisierungsschicht (12) zu dem Substrat (11) hin ausläuft.

5. Substratanordnung (10) nach einem der vorhergehenden Ansprüche, **dadurch gekennzeichnet, dass** die Stabilisierungsschicht (12) derart ausgestaltet und auf dem Substrat (11) angeordnet ist, dass sie einen durch das Auflaminieren der Deckschicht (32) bei der Herstellung des Datenträgers (1) bewirkten Druck der elektrischen Komponente (21) auf das Substrat (11) flächig verteilt und dadurch reduziert.

6. Substratanordnung (10) nach einem der vorhergehenden Ansprüche, **dadurch gekennzeichnet, dass** das Material der Stabilisierungsschicht (12) härter ist als das Material des Substrats (11).

7. Substratanordnung (10) nach einem der vorhergehenden Ansprüche, **dadurch gekennzeichnet, dass** das Material der Stabilisierungsschicht (12) einen Schmelzpunkt besitzt, der größer ist, als eine bei der Herstellung des Datenträgers (1) zum Auflaminieren der Deckschicht (32) auf die Substratanordnung (10) erforderliche Temperatur.

8. Kartenförmiger Datenträger (1) in Form eines laminierten Schichtverbunds, **dadurch gekennzeichnet, dass** der Datenträger (1) eine Substratanordnung (10) nach einem der Ansprüche 1 bis 8 und eine darauf auflaminierte Deckschicht (32) umfasst, sowie eine auf der Stabilisierungsschicht (12) angeordnete und mit der Leiterbahn (13) elektrische leitend verbundene elektrische Komponente (21), über die sich die Deckschicht (32) hinweg erstreckt.

9. Kartenförmiger Datenträger (1) nach Anspruch 8, **dadurch gekennzeichnet, dass** eine dem Substrat (11) zugewandte Fläche der Stabilisierungsschicht (12) größer ist als eine dem Substrat (11) zugewandte Fläche der elektrischen Komponente (21).

10. Kartenförmiger Datenträger (1) nach Anspruch 8 oder 9, **dadurch gekennzeichnet, dass** der Datenträger (1) eine zwischen dem Substrat (11) und der Deckschicht (32) liegende Zwischenschicht (31) umfasst, die zumindest die elektrische Komponente (21) ausspart.

11. Kartenförmiger Datenträger (1) nach einem der Ansprüche 8 bis 10, **dadurch gekennzeichnet, dass** es sich bei der elektrischen Komponente (21) um einen Mikrochip handelt und/oder die Leiterbahn (13) eine Antenne bildet.

12. Verfahren zum Herstellen einer Substratanordnung (10) für einen kartenförmigen Datenträger (1), umfassend ein Bereitstellen (S1) eines Substrats (11) und einer elektrischen Leiterbahn (13), **gekennzeichnet durch** die weiteren Schritte des
Anordnens (S2) einer Stabilisierungsschicht (12) auf einem Bereich des Substrats (11), und des
Anordnens (S3) der elektrischen Leiterbahn (13) derart, dass sie sich von einer dem Substrat (11) abgewandten Seite der Stabilisierungsschicht (12) zu einem nicht von der Stabilisierungsschicht (12) bedeckten Bereich des Substrats (11) erstreckt,
wobei die Stabilisierungsschicht (12) derart ausgestaltet wird, dass beim Auflaminieren die Stabilisierungsschicht (12) in das Substrat (11) eingedrückt wird, und die Leiterbahn (13) sich derart von der Stabilisierungsschicht (12) zu dem Substrat (11) erstreckend angeordnet wird, dass eine bei der Herstellung des Datenträgers (1) auf der Stabilisierungsschicht (12) angeordnete und mit der Leiterbahn (13) elektrisch leitend verbundene elektrische Komponente (21) bei einem Auflaminieren einer sich über die elektrische Komponente (21) erstreckenden Deckschicht (32) in elektrisch leitender Verbindung mit der Leiterbahn (13) verbleibt.

13. Verfahren nach Anspruch 12, **dadurch gekennzeichnet, dass** die Schritte des Ausgestaltens der Stabilisierungsschicht (12) und Anordnens der sich von der Stabilisierungsschicht (12) zu dem Substrat (11) erstreckenden Leiterbahn (13) derart ausgeführt werden, dass eine Substratanordnung (1) nach einem der Ansprüche 2 bis 7 erzeugt wird.

14. Verfahren zum Herstellen eines kartenförmigen Datenträgers (1) in Form eines laminierten Schichtverbundes **gekennzeichnet durch** die Schritte des Herstellens einer Substratanordnung (10) gemäß einem Verfahren nach einem der Ansprüche 12 oder 13, des Anordnens (S4) einer elektrischen Komponente (21) auf der Stabilisierungsschicht (12), des elektrisch leitenden Verbindens (S5) der elektrischen Komponente (21) mit der Leiterbahn (13) und des Auflaminierens (S6) einer Deckschicht (32) auf die Substratanordnung (10), derart, dass sich die Deckschicht (32) über die elektrische Komponente (21) hinweg erstreckt.

## Claims

1. A substrate arrangement (10) for manufacturing a card-shaped data carrier (1), comprising a substrate (11) and at least one electric conductor path (13) arranged on the substrate (11), **characterized in that**
the substrate arrangement (10) comprises a stabilization layer (12) covering a region of the substrate (11), and
the conductor path (13) extends from a side of the stabilization layer (12) facing away from the substrate (11) to a region of the substrate (11) not covered by the stabilization layer (12), wherein
the stabilization layer (12) is configured such that upon laminating the stabilization layer (12) is pressed into the substrate (11), and the conductor path (13) extends from the stabilization layer (12) to the substrate (11) such that an electric component (21) arranged on the stabilization layer (12) and electroconductively connected with the conductor path (13) upon manufacture of the data carrier (1) remains in electroconductive connection with the conductor path (13) upon a laminating of a cover layer (32) extending over the electric component (21).

2. The substrate arrangement (10) according to claim 1, **characterized in that** the stabilization layer (12) is configured such and the conductor path (13) extends from the stabilization layer (12) to the substrate (11) such that upon a pressure of the stabilization layer (12) on the substrate (11), which is effected by the laminating of the cover layer (32) when manufacturing the data carrier (1), the conductor path (13) is substantially only compressed and/or bent.

3. The substrate arrangement (10) according to claim 1 or 2, **characterized in that** at least one edge region of the stabilization layer (12), over which the conductor path (13) extends from the stabilization layer (12) to the substrate (11), is configured such that upon a pressure of the stabilization layer (12) on the substrate (11), which is effected by the laminating of the cover layer (32) when manufacturing the data carrier (1), the conductor path (13) is substantially only compressed and/or bent.

4. The substrate arrangement (10) according to claim 3, **characterized in that** the at least one edge region (12b) of the stabilization layer (12) tapers out from the stabilization layer (12) toward the substrate (11).

5. The substrate arrangement (10) according to any of the preceding claims, **characterized in that** the stabilization layer (12) is configured and arranged on the substrate (11) such that it areally distributes a pressure of the electric component (21) on the substrate (11), which is effected by the laminating of the cover layer (32) when manufacturing the data carrier (1), and thus reduces it.

6. The substrate arrangement (10) according to any of the preceding claims, **characterized in that** the material of the stabilization layer (12) is harder than the material of the substrate (11).

7. The substrate arrangement (10) according to any of the preceding claims, **characterized in that** the material of the stabilization layer (12) has a melting point which is higher than a temperature required for laminating the cover layer (32) onto the substrate arrangement (10) when manufacturing the data carrier (1).

8. A card-shaped data carrier (1) in the form of a laminated layered composite, **characterized in that** the data carrier (1) comprises a substrate arrangement (10) according to any of claims 1 to 8 and a cover layer (32) laminated thereon, as well as an electric component (21) arranged on the stabilization layer (12) and electroconductively connected with the conductor path (13), over which electric component the cover layer (32) extends.

9. The card-shaped data carrier (1) according to claim 8, **characterized in that** an area of the stabilization layer (12) facing the substrate (11) is larger than an area of the electric component (21) facing the substrate (11).

10. The card-shaped data carrier (1) according to claim 8 or 9, **characterized in that** the data carrier (1) comprises an intermediate layer (31) located between the substrate (11) and the cover layer (32), which intermediate layer leaves blank at least the electric component (21).

11. The card-shaped data carrier (1) according to any of claims 8 to 10, **characterized in that** the electric component (21) is a microchip and/or the conductor path (13) forms an antenna.

12. A method for manufacturing a substrate arrangement (10) for a card-shaped data carrier (1), comprising supplying (S1) a substrate (11) and an electric conductor path (13), **characterized by** the further steps of
arranging (S2) a stabilization layer (12) on a region of the substrate (11), and
arranging (S3) the electric conductor path (13) such that it extends from a side of the stabilization layer (12) facing away from the substrate (11) to a region of the substrate (11) not covered by the stabilization layer (12),
wherein the stabilization layer (12) is configured such that upon laminating the stabilization layer (12) is pressed into the substrate (11), and the conductor path (13) is arranged extending from the stabilization layer (12) to the substrate (11) such that an electric component (21) arranged on the stabilization layer (12) and electroconductively connected with the conductor path (13) upon manufacture of the data carrier (1) remains in electroconductive connection with the conductor path (13) upon a laminating of a cover layer (32) extending over the electric component (21).

13. The method according to claim 12, **characterized in that** the steps of configuring the stabilization layer (12) and arranging the conductor path (13) extending from the stabilization layer (12) to the substrate (11) are executed such that a substrate arrangement (1) according to any of claims 2 to 7 is produced.

14. A method for manufacturing a card-shaped data carrier (1) in the form of a laminated layered composite, **characterized by** the steps of manufacturing a substrate arrangement (10) according to a method after any of claims 12 or 13, arranging (S4) an electric component (21) on the stabilization layer (12), electroconductively connecting (S5) the electric component (21) with the conductor path (13) and laminating (S6) a cover layer (32) onto the substrate arrangement (10), such that the cover layer (32) extends over the electric component (21).

## Revendications

1. Agencement de substrat (10) destiné à la fabrication d'un support de données (1) en forme de carte, comprenant un substrat (11) ainsi qu'au moins une piste conductrice (13) électrique agencée sur le substrat (11), **caractérisé en ce que**
l'agencement de substrat (10) comprend une couche de stabilisation (12) recouvrant une zone du substrat (11), et
la piste conductrice (13) s'étend d'un côté de la couche de stabilisation (12) détourné du substrat (11) à une zone du substrat (11) non recouverte par la couche de stabilisation (12), cependant que
la couche de stabilisation (12) est réalisée de telle façon que, lors du laminage, la couche de stabilisation (12) est enfoncée dans le substrat (11), et que la piste conductrice (13) s'étend de telle manière de la couche de stabilisation (12) au substrat (11) qu'un composant électrique (21) agencé sur la couche de stabilisation (12) et relié de manière électriquement conductrice à la piste conductrice (13) lors de la fabrication du support de données (1), demeure, lors d'un laminage d'une couche de recouvrement (32) s'étendant par-dessus le composant électrique (21), en liaison électriquement conductrice avec la piste conductrice (13).

2. Agencement de substrat (10) selon la revendication 1, **caractérisé en ce que** la couche de stabilisation (12) est réalisée de telle façon et que la piste conductrice (13) s'étend de telle manière de la couche de stabilisation (12) au substrat (11) que la piste conductrice (13) est, lors d'une pression, de la couche de stabilisation (12) sur le substrat (11), engendrée par le laminage de la couche de recouvrement (32) lors de la fabrication du support de données (1), essentiellement seulement refoulée ou courbée.

3. Agencement de substrat (10) selon la revendication 1 ou 2, **caractérisé en ce qu'**au moins une zone de bordure de la couche de stabilisation (12) sur laquelle passe la piste conductrice (13) en allant de la couche de stabilisation (12) au substrat (11) est réalisée de telle façon que la piste conductrice (13) est, lors d'une pression, de la couche de stabilisation (12) sur le substrat (11), engendrée par le laminage de la couche de recouvrement (32) lors de la fabrication du support de données (1), essentiellement seulement refoulée ou courbée.

4. Agencement de substrat (10) selon la revendication 3, **caractérisé en ce que** la au moins une zone de bordure (12b) de la couche de stabilisation (12) vient expirer de la couche de stabilisation (12) au substrat (11).

5. Agencement de substrat (10) selon une des revendications précédentes, **caractérisé en ce que** la couche de stabilisation (12) est réalisée de telle façon et est agencée de telle manière sur le substrat (11) qu'elle répartit en surface et réduit ainsi une pression, du composant électrique (21) sur le substrat (11), engendrée par le laminage de la couche de recouvrement (32) lors de la fabrication du support de données (1).

6. Agencement de substrat (10) selon une des revendications précédentes, **caractérisé en ce que** le matériau de la couche de stabilisation (12) est plus dur que le matériau du substrat (11).

7. Agencement de substrat (10) selon une des revendications précédentes, **caractérisé en ce que** le matériau de la couche de stabilisation (12) possède un point de fusion plus élevé qu'une température nécessaire, lors de la fabrication du support de données (1), au laminage de la couche de recouvrement (32) sur l'agencement de substrat (10).

8. Support de données (1) en forme de carte sous forme d'un composite multicouche laminé, **caractérisé en ce que** le support de données (1) comprend un agencement de substrat (10) selon une des revendications de 1 à 8 et une couche de recouvrement (32) laminée par-dessus, ainsi qu'un composant électrique (21) agencé sur la couche de stabilisation (12) et relié de manière électriquement conductrice à la piste conductrice (13) par dessus lequel s'étend la couche de recouvrement (32).

9. Support de données (1) en forme de carte selon la revendication 8, **caractérisé en ce qu'**une surface de la couche de stabilisation (12) tournée vers le substrat (11) est supérieure à une surface du composant électrique (21) tournée vers le substrat (11).

10. Support de données (1) en forme de carte selon la revendication 8 ou 9, **caractérisé en ce que** le support de données (1) comprend une couche intermédiaire (31) qui se trouvent entre le substrat (11) et la couche de recouvrement (32) et qui épargne au moins le composant électrique (21).

11. Support de données (1) en forme de carte selon une des revendications de 8 à 10, **caractérisé en ce que** le composant électrique (21) consiste en une micro-puce et/ou **en ce que** la piste conductrice (13) constitue une antenne.

12. Procédé de fabrication d'un agencement de substrat (10) destiné à un support de données (1) en forme de carte, comprenant la mise à disposition (S1) d'un substrat (11) et d'une piste conductrice (13) électrique, **caractérisé par** les étapes subséquentes de
l'agencement (S2) d'une couche de stabilisation (12) dans une zone du substrat (11), et de
l'agencement (S3) de la piste conductrice (13) électrique de telle manière qu'elle s'étend d'un côté de la couche de stabilisation (12) détourné du substrat (11) à une zone du substrat (11) non recouverte par la couche de stabilisation (12),
cependant que la couche de stabilisation (12) est réalisée de telle façon que, lors du laminage, la couche de stabilisation (12) est enfoncée dans le substrat (11), et que la piste conductrice (13) est agencée de manière s'étendant de telle manière de la couche de stabilisation (12) au substrat (11) qu'un composant électrique (21) agencé sur la couche de stabilisation (12) et relié de manière électriquement conductrice à la piste conductrice (13) lors de la fabrication du support de données (1), demeure, lors d'un laminage d'une couche de recouvrement (32) s'étendant par-dessus le composant électrique (21), en liaison électriquement conductrice avec la piste conductrice (13).

13. Procédé selon la revendication 12, **caractérisé en ce que** les étapes de la réalisation de la couche de stabilisation (12) et de l'agencement de la piste conductrice (13) s'étendant de la couche de stabilisation (12) au substrat (11) sont effectuées de telle manière qu'un agencement de substrat (1) selon une des revendications de 2 à 7 est généré.

14. Procédé de fabrication d'un support de données (1) en forme de carte sous forme d'un composite multicouche laminé, **caractérisé par** les étapes de la fabrication d'un agencement de substrat (10) suivant un procédé selon une des revendications 12 ou 13, de l'agencement (S4) d'un composant électrique (21) sur la couche de stabilisation (12), de la liaison (S5) électriquement conductrice du composant électrique (21) avec la piste conductrice (13) et du laminage (S6) d'une couche de recouvrement (32) sur l'agencement de substrat (10) de telle façon que la couche de recouvrement (32) s'étend par-dessus le composant électrique (21).
